(19) Europäisches Patentamt
European Patent Office
Office européen des brevets

(11) EP 4 776 515 A1

(12) EUROPEAN PATENT APPLICATION

(43) Date of publication:
15.07.2026 Bulletin 2026/29

(21) Application number: 26150969.9

(22) Date of filing: 09.01.2026

(51) International Patent Classification (IPC):
H03M 1/10 (2006.01)    H03M 1/46 (2006.01)

(52) Cooperative Patent Classification (CPC):
H03M 1/468; H03M 1/1038

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 10.01.2025 CN 202510043043

(71) Applicant: GigaDevice Semiconductor Inc.
Haidian, Beijing (CN)

(72) Inventor: ZHANG, Zhuan
Beijing (CN)

(74) Representative: dompatent
Partnerschaft von
Patentanwälten und Rechtsanwälten mbB
Deichmannhaus am Dom
Bahnhofsvorplatz 1
50667 Köln (DE)

(54) SAR ADC AND METHOD OF CALIBRATING THE SAME

(57) The present invention provides a successive approximation register (SAR) analogto-digital converter (ADC) and a method of calibrating the SAR ADC, in which each of LSB and MSB capacitor arrays in a DAC can be used to calibrate weights of capacitors in the other capacitor array. This dispenses with the use of a separate calibration DAC resulting in a simpler circuit. The method can be carried out prior to normal operation of the SAR ADC, adding flexibility to initial design of the SAR ADC.

Fig. 2

EP 4 776 515 A1

**Description**

**TECHNICAL FIELD**

The present invention relates to the field of analog-to-digital conversion (ADC) technology, and particularly to a successive approximation register (SAR) analog-to-digital converter (ADC) and a method of calibrating the SAR ADC.

**BACKGROUND**

Successive approximation register (SAR) analog-to-digital converters (ADCs) provide a variety of advantages, including low power consumption, a small size, fast operation and good accuracy. They are commonly used in medium-to-high resolution ADC applications requiring a sampling rate lower than 5 mega samples per second (MSPS).

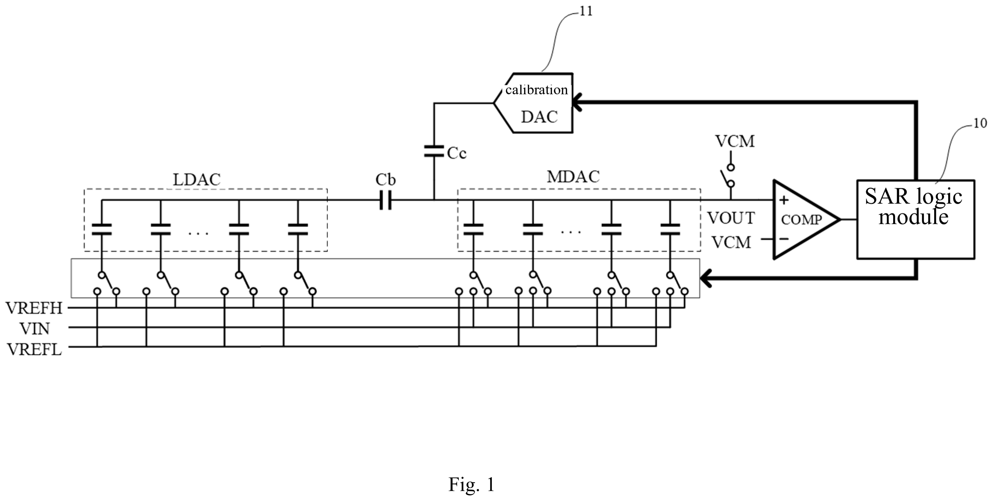

Referring to Fig. 1, a SAR ADC essentially consists of a comparator COMP, a SAR logic module and a digital-to-analog converter (DAC). The comparator COMP compares an output signal VOUT of the DAC with a common-mode level VCM and provides a result of the comparison to the SAR logic module 10. The SAR logic module 10 processes the result of the comparison from the comparator COMP and thereby determines how the DAC is switched on the next iteration and a quantization level for a corresponding bit, allowing for conversion on the next iteration.

In the SAR ADC, the DAC is generally implemented by a segmented capacitor array, which features fewer capacitors and a smaller area. As shown in Fig. 1, the segmented capacitor array may consist of a k-bit (where k is an integer greater than 1) most significant bit (MSB) capacitor array MDAC and an m-bit (where m is also an integer greater than 1) least significant bit (LSB) capacitor array LDAC, which are connected to each other by a bridge capacitor Cb, with MDAC providing an output terminal of the DAC. During the design of the segmented capacitor array of the DAC, the capacitance of the bridge capacitor Cb must ensure correct weights of capacitors in the DAC and the linearity of the entire DAC. The capacitance of the bridge capacitor Cb may be equal to a non-integer multiple of a unit capacitance Cu. Parasitic capacitance and any capacitance deviation of the bridge capacitor Cb, as well as capacitance mismatch of MDAC and LDAC, may introduce significant nonlinearity, which will degrade the performance of the SAR ADC and necessitates calibration.

Referring to Fig. 1, in a conventional calibration method, a calibration DAC 11 consisting of a capacitor array is added for calibrating MDAC. The calibration DAC 11 is connected to the output terminal of the DAC through a coupling capacitor Cc and converts errors of the capacitors of MDAC into digital values CAL_DAC_i, which are then stored in a register (not shown). During normal operation, the ADC outputs corresponding calibration values CAL_DAC_i to the calibration DAC 11 for compensating for the errors of the capacitors of MDAC.

This calibration method is associated with the problems as follows:

    1. As LDAC cannot be calibrated, the requirements on capacitance design of the bridge capacitor Cb remain demanding, leading to limited flexibility in ADC design.
    2. At a greater number of bits of MDAC, the capacitor array of the calibration DAC 11 may occupy a comparable area to that of MDAC, leading to increased chip cost.

**SUMMARY**

It is an object of the present invention to provide a successive approximation register (SAR) analog-to-digital converter (ADC) and a method of calibrating the SAR ADC. The method is able to calibrate capacitors in a digital-to-analog converter (DAC) in the SAR ADC to avoid performance degradation caused by capacitance mismatch, while allowing more flexibility in ADC design.

To this end, the present invention provides a method of calibrating a SAR ADC including a digital-to-analog converter (DAC). The DAC includes a bridge capacitor, a least significant bit (LSB) capacitor array and a most significant bit (MSB) capacitor array. The MSB capacitor array includes capacitors each including a first electrode plate coupled to an electrode plate of the bridge capacitor, which provides an output terminal of the MSB capacitor array. The LSB capacitor array includes capacitors each including a first electrode plate coupled to another electrode plate of the bridge capacitor, which provides an output terminal of the LSB capacitor array. The method includes the steps of:

    S1) measuring weights of the capacitors of the MSB capacitor array by the LSB capacitor array;
    S2) measuring weights of the capacitors of the LSB capacitor array by the MSB capacitor array;
    S3) iteratively repeating S1 and S2 for a number of times, deriving a weight matrix of the entire DAC; and
    S4) normalizing the weight matrix of the entire DAC to a weight matrix with a target number of bits of resolution.

Therefore, in this SAR ADC, each of the LSB and MSB capacitor arrays in the DAC can be used to calibrate the weights of the capacitors in the other capacitor array, dispensing with the use of a separate calibration DAC and resulting in a simpler circuit. In addition, the method can be carried out prior to normal operation of the SAR ADC, adding flexibility to initial design of the SAR ADC, in particular to capacitance design of the bridge capacitor and to the DAC's segmented capacitor array design. The capacitance of the bridge capacitor ($C_b$), the number of bits (k) of the MSB capacitor array (MDAC) and the number (k) of bits of the LSB capacitor array (LDAC) may be determined according to a capacitance mismatch range of the DAC, weight calibration accuracy and a target or design number of bits of resolution of the SAR ADC. The weight of LDAC does not need to be scaled in binary relative to the MDAC. During ADC conversion, a portion of the MDAC and LDAC can be selected for sampling and conversion. It is only necessary that the total weight of the selected capacitors in the LDAC is not less than the weight of the selected lowest bit of the MDAC, and the resolution of the entire ADC meets the design target resolution.

Optionally, in step S1, the weight of the least significant one of the capacitors in the MSB capacitor array may be measured by the LSB capacitor array using a process including:

S11) connecting the output terminal of the MSB capacitor array to a common-mode level, a second electrode plate of the least significant capacitor in the MSB capacitor array to a first reference voltage, and second electrode plates of the remaining capacitors in the MSB capacitor array and of the capacitors in the LSB capacitor array to a second reference voltage;

S12) disconnecting the common-mode level from the output terminal of the MSB capacitor array and connecting the second electrode plate of the least significant capacitor in the MSB capacitor array instead to the second reference voltage;

S13) performing successive approximation conversion by the SAR ADC, deriving a first conversion result; and

S14) deriving the weight of the least significant capacitor in the MSB capacitor array from the weights of the capacitors in the LSB capacitor array and the first conversion result.

In this way, the LSB capacitor array of the DAC can measure the weight of the least significant capacitor in the MSB capacitor array of the DAC by simple circuit operations.

Optionally, in step S1, steps S11 to S13 may be performed for a number of times prior to step S14, and the first conversion result may be obtained as an average of the repetitions. This allows for more accurate measurement of the weight of the least significant capacitor in the MSB capacitor array.

Optionally, in step S1, with each of the remaining capacitors in the MSB capacitor array to be measured being taken as a first capacitor under measurement, the weight of the first capacitor under measurement may be measured by the LSB capacitor array using a process including:

S15) connecting the output terminal of the MSB capacitor array to the common-mode level, the second electrode plates of the first capacitor under measurement and of the most significant one of the capacitors in the LSB capacitor array both to the first reference voltage, and the second electrode plates of the remaining capacitors in the MSB capacitor array and of the remaining capacitors in LSB capacitor array all to the second reference voltage;

S16) disconnecting the common-mode level from the output terminal of the MSB capacitor array and connecting the second electrode plate of the first capacitor under measurement instead to the second reference voltage and the second electrode plates of capacitors in the MSB capacitor array of less significance than the first capacitor under measurement all instead to the first reference voltage;

S17) performing successive approximation conversion by the SAR ADC, deriving a second conversion result; and

S18) deriving the weight of the first capacitor under measurement from the weights of the capacitors in the LSB capacitor array and from the second conversion result.

In this way, the LSB capacitor array of the DAC can measure the weights of the other capacitors than the least significant one in the MSB capacitor array of the DAC by simple circuit operations.

Optionally, in step S1, steps S15 to S17 may be performed for a number of times prior to step S18, and the second conversion result may be obtained as an average of the repetitions. This allows for more accurate measurement of the weights of the other capacitors than the least significant one in the MSB capacitor array.

Optionally, there may be m capacitors $CL_0$-$CL_{m-1}$ in the LSB capacitor array, and their weights may be expressed as Weight_L=[Weight_L(m-1),..., Weight_L(0)], wherein there are k capacitors $CM_0$-$CM_{k-1}$ in the MSB capacitor array;

the weight of the least significant capacitor $CM_0$ in the MSB capacitor array is expressed as:

$$\text{Weight\_M(0)}=\text{RES0\_1}*\text{Weight\_L};$$

the weight of the first capacitor under measurement $CM_i$ is expressed as:

$$\text{Weight\_M(i)}=\text{RES1}+\sum_{j=0}^{i-1}\text{Weight\_M(j)}\quad,$$

where RES1=RES0_2*Weight_L-Weight_L(m-1); and
the weights of the capacitors in the MSB capacitor array are expressed as: Weight_M=[Weight_M(k-1),..., Weight_M(0)],
wherein RES0_1 represents the first conversion result, RES0_2 represents the second conversion result, and i and j are both integers and satisfy $0<i\leq k-1$ and $0\leq j\leq i-1$, and/or
the weights Weight_L of the capacitors in the LSB capacitor array are initially $[2^{m-1}, 2^{m-2},...,2,1]$.

Optionally, in step S2, the weight of the least significant one of the capacitors in the LSB capacitor array may be measured by the MSB capacitor array using a process including:

S21) connecting the output terminal of the LSB capacitor array to a common-mode level, a second electrode plate of the least significant capacitor in the LSB capacitor array to a first reference voltage, and second electrode plates of the remaining capacitors in the LSB capacitor array and of the capacitors in the MSB capacitor array to a second reference voltage;
S22) disconnecting the common-mode level from the output terminal of the LSB capacitor array and connecting the second electrode plate of the least significant capacitor in the LSB capacitor array instead to the second reference voltage;
S23) performing successive approximation conversion by the SAR ADC, deriving a third conversion result; and
S24) deriving the weight of the least significant capacitor in the LSB capacitor array from the weights of the capacitors in the MSB capacitor array and from the third conversion result.

In this way, the MSB capacitor array of the DAC can measure the weight of the least significant capacitor in the LSB capacitor array of the DAC by simple circuit operations.
Optionally, in step S2, steps S21 to S23 may be performed for a number of times prior to step S24, and the third conversion result may be obtained as an average of the repetitions. This allows for more accurate measurement of the weight of the least significant capacitor in the LSB capacitor array.
Optionally, in the step S2, with each of the remaining capacitors in the LSB capacitor array to be measured being taken as a second capacitor under measurement, the weight of the second capacitor under measurement may be measured by the MSB capacitor array using a process including:

S25) connecting the output terminal of the LSB capacitor array to the common-mode level, the second electrode plates of the second capacitor under measurement and of the most significant one of the capacitors in the MSB capacitor array both to the first reference voltage, and the second electrode plates of the remaining capacitors in the MSB capacitor array and of the remaining capacitors in LSB capacitor array all to the second reference voltage;
S26) disconnecting the common-mode level from the output terminal of the LSB capacitor array and connecting the second electrode plate of the second capacitor under measurement instead to the second reference voltage and the second electrode plates of capacitors in the LSB capacitor array of less significance than the second capacitor under measurement all instead to the first reference voltage;
S27) performing successive approximation conversion by the SAR ADC, deriving a fourth conversion result; and
S28) deriving the weight of the second capacitor under measurement from the weights of the capacitors in the MSB capacitor array and from the fourth conversion result.

In this way, the MSB capacitor array of the DAC can measure the weights of the other capacitors than the least significant one in the LSB capacitor array of the DAC by simple circuit operations.
Optionally, in step S2, steps S25 to S27 may be performed for a number of times prior to step S28, and the fourth conversion result may be obtained as an average of the repetitions. This allows for more accurate measurement of the weights of the other capacitors than the least significant one in the LSB capacitor array.
Optionally, there may be m capacitors $CL_0$-$CL_{m-1}$ in the LSB capacitor array and k capacitors $CM_0$-$CM_{k-1}$ in the MSB capacitor array, and the weights of the capacitors in the MSB capacitor array may be expressed as weight Weight_M= [Weight_M(k-1),..., Weight_M(0)], wherein:

the weight of the least significant capacitor $CL_0$ in the LSB capacitor array is expressed as:

$$Weight\_L(0)=RES0\_3*Weight\_M;$$

the weight of the second capacitor under measurement $CL_i$ is expressed as:

$$Weight\_L(i)=RES2+\sum_{j=0}^{i-1} Weight\_L(j) \quad,$$

where RES2=RES0_4*Weight_M-Weight_M(k-1); and

the weights of the capacitors in the LSB capacitor array are expressed as: Weight_L=[Weight_L(m-1),..., Weight_L(0)]./ Weight _L(0),

wherein RES0_3 represents the third conversion result, RES0_4 represents the fourth conversion result, and i and j are both integers and satisfy $0<i\leq m-1$ and $0\leq j\leq i-1$.

Optionally, the m capacitors $CL_0$-$CL_{m-1}$ and the k capacitors $CM_0$-$CM_{k-1}$ may be both weighted in powers of two; the segmented capacitor array further includes a terminal capacitor, wherein the weight matrix of the entire DAC in step S3 is obtained as DAC_Weight_raw= [MDAC_Weight, LDAC_Weight], and the weight matrix with the target number of bits of resolution N in step S4 as

$$DAC\_Weight\_normal=DAC\_Weight\_raw.*\left[2^N \middle/ \left(\sum MDAC\_Weight + Weight\_M\_(T)\right)\right] \quad,$$

where $\sum$MDAC_Weight is the sum of the weights of the capacitors in the MSB capacitor array, and/or Weight_M_(T) is a weight of the terminal capacitor measured by the LSB capacitor array.

Based on the same inventive concept, the present invention also provides a successive approximation register (SAR) analog-to-digital converter (ADC) including:

a digital-to-analog converter (DAC) including a bridge capacitor, a least significant bit (LSB) capacitor array and a most significant bit (MSB) capacitor array, the MSB capacitor array including capacitors each including a first electrode plate coupled to an electrode plate of the bridge capacitor, which provides an output terminal of the MSB capacitor array, the LSB capacitor array including capacitors each including a first electrode plate coupled to another electrode plate of the bridge capacitor, which provides an output terminal of the LSB capacitor array,

a comparison module, including: a first input terminal coupled to both the output terminal of the LSB capacitor array and the output terminal of the MSB capacitor array; and a second input terminal coupled to a common-mode level, the comparison module configured to compare an output of the MSB capacitor array or of the LSB capacitor array with the common-mode level; and

a SAR logic and digital calibration module including an input terminal coupled to an output terminal of the comparison module, the SAR logic and digital calibration module configured to perform successive approximation conversion based on an output of the comparison module and thereby implement the method as defined above.

Optionally, each of the capacitors in the DAC may include a second electrode plate coupled to a corresponding switch, and the SAR logic and digital calibration module may also be configured to control each of the capacitors in the DAC so that its second electrode plate is switched to be connected to at least one of a first reference voltage, a second reference voltage and an input voltage.

Optionally, the comparison module may include:

a first switch and a first comparator, the first switch including a terminal coupled to the common-mode level and another terminal coupled to both a first input terminal of the first comparator and the output terminal of the MSB capacitor array, the first comparator including a second input terminal coupled to the common-mode level;

a second switch and a second comparator, the second switch including a terminal coupled to the common-mode level and another terminal coupled to both a first input terminal of the second comparator and the output terminal of the LSB capacitor array, the second comparator including a second input terminal coupled to the common-mode level; and

a multiplexer including a first input terminal coupled to an output terminal of the first comparator, a second input terminal coupled to an output terminal of the second comparator and an output terminal coupled to an input terminal of the SAR logic and digital calibration module,

wherein the multiplexer routes a result of comparison from the first comparator to the SAR logic and digital calibration module to allow the LSB capacitor array to measure weights of the capacitors in the MSB capacitor array, and routes a result of comparison from the second comparator to the SAR logic and digital calibration module to allow the MSB capacitor array to measure weights of the capacitors in the LSB capacitor array.

Optionally, the comparison module may include:

a third comparator including a second input terminal coupled to the common-mode level and an output terminal coupled to an input terminal of the SAR logic and digital calibration module;
a third switch including a terminal coupled to the common-mode level and another terminal selectively coupled to the output terminal of the MSB capacitor array or to the output terminal of the LSB capacitor array or to a first input terminal of the third comparator; and
a fourth switch including a terminal coupled to a first input terminal of the third comparator and another terminal selectively coupled to the output terminal of the LSB capacitor array or to the output terminal of the MSB capacitor array.

**BRIEF DESCRIPTION OF THE DRAWINGS**

Those of ordinary skill in the art will understand that the following drawings are presented to enable a better understanding of the present invention and not intended to limit the scope thereof in any sense, in which:

Fig. 1 is a schematic circuit diagram of a conventional SAR ADC;
Fig. 2 is an exemplary schematic circuit diagram of a SAR ADC according to an embodiment of the present invention;
Fig. 3 is a schematic flowchart of a method of calibrating a SAR ADC according to an embodiment of the present invention;
Fig. 4 is a schematic flowchart of a process to calibrate weights of CMT and $CM_0$ in MDAC in a method of calibrating a SAR ADC according to an embodiment of the present invention;
Fig. 5 is a schematic flowchart of a process to calibrate weights of other capacitors in MDAC in a method of calibrating a SAR ADC according to an embodiment of the present invention;
Fig. 6 is a schematic flowchart of a process to calibrate a weight of CL0 in LDAC in a method of calibrating a SAR ADC according to an embodiment of the present invention;
Fig. 7 is a schematic flowchart of a process to calibrate weights of other capacitors in LDAC in a method of calibrating a SAR ADC according to an embodiment of the present invention; and
Fig. 8 is another exemplary schematic circuit diagram of the SAR ADC according to an embodiment of the present invention.

**DETAILED DESCRIPTION**

The following description sets forth numerous specific details in order to provide a more thorough understanding of the present invention. However, it will be apparent to those skilled in the art that the present invention can be practiced without one or more of these specific details. In other instances, well-known technical features have not been described in order to avoid unnecessary obscuring of the invention. It is to be understood that the invention may be embodied in many different forms and should not be construed as being limited to the embodiments set forth below. Rather, these embodiments are provided so that this disclosure is thorough and conveys the scope of the invention to those skilled in the art. In the drawings, like reference numerals refer to like elements throughout. It will be understood that when an element is referred to as being "connected to" or "coupled to" another element, it can be directly connected or coupled to the other element, or intervening elements may also be present. In contrast, when an element is referred to as being "directly connected to" another element, there are no intervening elements. As used herein, the singular forms "a", "an" and "the" are intended to include the plural forms as well, unless the context clearly indicates otherwise. It will be further understood that the term "comprising" specifies the presence of stated features, steps, operations, elements, and/or components, but do not preclude the presence or addition of one or more other features, steps, operations, elements, components, and/or groups thereof. As used herein, the term "and/or" includes any and all combinations of the associated listed items.

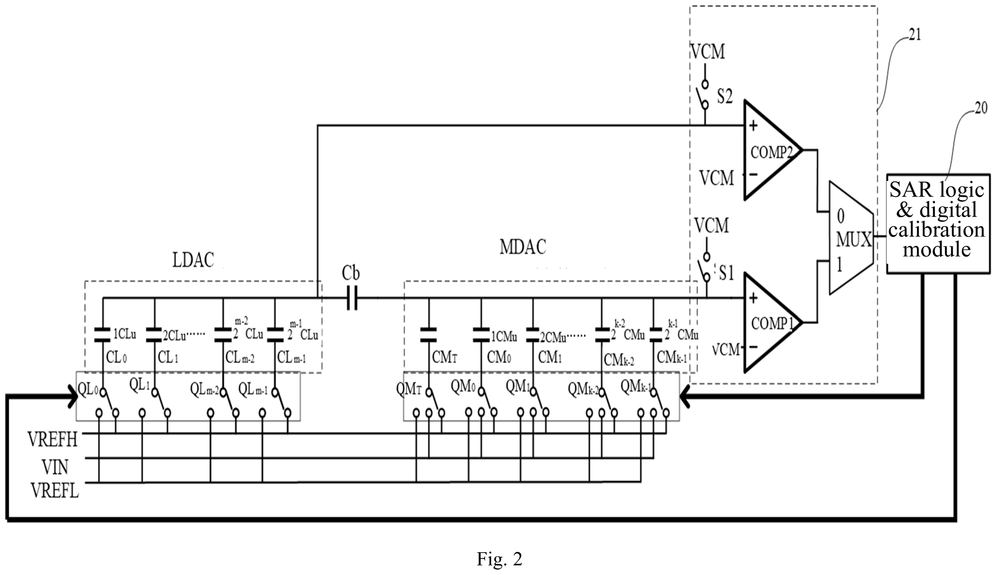

Referring to Fig. 2, in one embodiment of the present invention, there is provided a successive approximation register (SAR) analog-to-digital converter (ADC) including a digital-to-analog converter (DAC), a comparison module 21 and a SAR logic and digital calibration module ("SAR Logic & Digital Calibration") 20.

The DAC may be of a segmented design and include a bridge capacitor $C_b$, a least significant bit (LSB) capacitor array (also referred to as an "LSB sub-DAC") LDAC and a most significant bit (MSB) capacitor array (also referred to as an "MSB sub-DAC"). The MSB capacitor array MDAC is a k-bit array consisting of capacitors $CM_0$-$CM_{k-1}$ weighted in powers

of two, and the LSB capacitor array LDAC is an m-bit array consisting of capacitors $CL_0$-$CL_{m-1}$ weighted in powers of two. In the MSB capacitor array MDAC, the capacitor $CM_0$ represents the least significant bit and has a capacitance of $1$ $CM_u$, and the capacitor $CM_{k-1}$ represents the most significant bit and has a capacitance of $2^{k-1}$ $CM_u$. $CM_u$ represents unit capacitance of the MSB capacitor array MDAC. In the LSB capacitor array LDAC, the capacitor $CL_0$ represents the least significant bit and has a capacitance of $1$ $CL_u$, and the capacitor $CL_{m-1}$ represents the most significant bit and has a capacitance of $2^{m-1}$ $CL_u$. $CL_u$ represents unit capacitance of the LSB capacitor array LDAC. In one example, $CM_u=CL_u=C_u$. In the following, the "other terminal" (or "other electrode plate") of $C_b$ refers to its top plate, and "one terminal" (or "one electrode plate") of $C_b$ refers to its bottom plate, as an example. Moreover, when used to describe any of $CM_0$-$CM_{k-1}$ and $CL_0$-$CL_{m-1}$, the term "first electrode plate" refers to its top plate, and the term "second electrode plate" refers to its bottom plate, as an example. In other embodiments of the present invention, the first electrode plates of $C_b$, $CM_0$-$CM_{k-1}$ and $CL_0$-$CL_{m-1}$ may be their bottom plates, and the second electrode plates of $C_b$, $CM_0$-$CM_{k-1}$ and $CL_0$-$CL_{m-1}$ may be their top plates.

Additionally, capacitance of the bridge capacitor $C_b$, k of the MSB capacitor array MDAC and m of the LSB capacitor array LDAC may be determined according to a capacitance mismatch range of the DAC, weight calibration accuracy and a target or design number of bits of resolution N of the SAR ADC (N is at most m+k). Parasitic capacitance presents at the bottom plate of the bridge capacitor $C_b$ contributes to total capacitance of the LSB and MSB capacitor arrays LDAC and MDAC and affects the weights of these capacitor arrays. Through calibrating and correcting the weights in accordance with the present invention, the influence of the parasitic capacitance of the bridge capacitor $C_b$ on the weights can be eliminated, avoiding performance degradation of the SAR ADC due to the presence of the bridge capacitor $C_b$. As such, the bridge capacitor $C_b$ will only have an impact on the resolution of the SAR ADC, and the parasitic capacitance present at the bottom plate of the bridge capacitor $C_b$ may be taken into account during design of the SAR ADC's resolution.

In the MSB capacitor array MDAC, the top plates of the capacitors $CM_0$-$CM_{k-1}$ are all coupled to one terminal (or one electrode plate, e.g., the bottom plate) of the bridge capacitor $C_b$, which provides an output terminal of the MSB capacitor array MDAC (and an output terminal of the DAC as well). The bottom plate of each of the capacitors $CM_0$-$CM_{k-1}$ is coupled to a terminal of a respective one of switches $QM_0$-$QM_{k-1}$. Another terminal of each switch $QM_0$-$QM_{k-1}$ is connectable to a different signal under the control of a digital value (or code) output from the SAR logic and digital calibration module 20. For example, the switches $QM_0$-$QM_{k-1}$ may be all tri-state switches, and said other terminal of each switch $QM_0$-$QM_{k-1}$ may be connectable to one of a first reference voltage VREFH, a second reference voltage VREFL and an analog input voltage VIN under the control of the SAR logic and digital calibration module 20. The first and second reference voltages VREFH and VREFL may be positive and negative versions of a single reference voltage VREF.

In the LSB capacitor array LDAC, the top plates of the capacitors $CL_0$-$CL_{m-1}$ are all coupled to the other terminal (or the other electrode plate, e.g., the top plate) of the bridge capacitor $C_b$, which provides an output terminal of the LSB capacitor array LDAC. The bottom plate of each of the capacitors $CL_0$-$CL_{m-1}$ is coupled to a terminal of a respective one of switches $QL_0$-$QL_{m-1}$. Another terminal of each switch $QL_0$-$QL_{m-1}$ is connectable to a different signal under the control of a digital value (or code) output from the SAR logic and digital calibration module 20. For example, the switches $QL_0$-$QL_{m-1}$ may be all bi-state switches, and said other terminal of each switch $QL_0$-$QL_{m-1}$ may be connectable to one of the first reference voltage VREFH and the second reference voltage VREFL under the control of the SAR logic and digital calibration module 20.

Optionally, the DAC of this embodiment may further include a terminal capacitor $CM_T$ having a first (e.g., top) electrode plate coupled to the output terminal of the DAC (i.e., said one terminal of the bridge capacitor, to which the top plates of $CM_0$-$CM_{k-1}$ are coupled) and a second (e.g., bottom) electrode plate coupled to a terminal of an associated switch $QM_T$. Another terminal of the switch $QM_T$ is connectable to a different signal under the control of a digital value (or code) output from the SAR logic and digital calibration module 20. For example, the switch $QM_T$ may be a tri-state switch, and said other terminal of the switch $QM_T$ may be connectable to one of the first reference voltage VREFH, the second reference voltage VREFL and the analog input voltage VIN under the control of the SAR logic and digital calibration module 20. In one example, $CM_T=CM_0=CMu$.

A first (e.g., non-inverting "+") input terminal of the comparison module 21 is coupled to both the output terminal of the LSB capacitor array LDAC and the output terminal of the MSB capacitor array MDAC. A second (e.g., inverting "-") input terminal of the comparison module 21 is coupled to a common-mode level VCM. The comparison module 21 is configured to compare an output of the MSB capacitor array MDAC or of the LSB capacitor array LDAC with the common-mode level VCM.

The SAR logic and digital calibration module 20 is configured to perform successive approximation conversion based on an output of the comparison module 21 and thereby output a digital value (or code) for connecting the switches $QL_0$-$QL_{m-1}$, $QM_T$ and the $QM_0$-$QM_{k-1}$ coupled to the bottom plates of $CL_0$-$CL_{m-1}$, $CM_T$ and $CM_0$-$CM_{k-1}$ in the DAC, and hence the bottom plates, to at least one of the first reference voltage VREFH, the second reference voltage VREFL and the analog input voltage VIN.

It will be understood that each of the comparison module 21 and the SAR logic and digital calibration module 20 may be of any suitable design.

As an example, referring to Fig. 2, the comparison module 21 includes a first switch S1, a second switch S2, a first comparator COMP1, a second comparator COMP2 and a multiplexer MUX. A terminal of the first switch S1 is coupled to the common-mode level VCM, and another terminal of the first switch S1 is coupled to a first (e.g., non-inverting "+") input terminal of the first comparator COMP1 and to the output terminal of the MSB capacitor array MDAC (i.e., to the top plates of the capacitors $CM_0$-$CM_{k-1}$). A second (e.g., inverting "-") input terminal of the first comparator COMP1 is coupled to the common-mode level VCM. A terminal of the second switch S2 is coupled to the common-mode level VCM, and another terminal thereof is coupled to a first (e.g., non-inverting "+") input terminal of the second comparator COMP2 and to the output terminal of the LSB capacitor array LDAC (i.e., to the top plates of the capacitors $CL_0$-$CL_{m-1}$). A second (e.g., inverting "-") input terminal of the second comparator COMP2 is coupled to the common-mode level VCM.

A first (e.g., "1") input terminal of the multiplexer MUX is coupled to an output terminal of the first comparator COMP1, and a second (e.g., "0") input terminal of the multiplexer MUX is coupled to an output terminal of the second comparator COMP2. An output terminal of the multiplexer MUX (which provides an output terminal of the comparison module 21) is coupled to an input terminal of the SAR logic and digital calibration module 20. The multiplexer MUX selectively routes a result of comparison from the first COMP1 or second COMP2 comparator to the SAR logic and digital calibration module 20, which then performs successive approximation conversion based on the output from the multiplexer MUX.

In the SAR ADC of this embodiment, the capacitances of the capacitors in the LSB capacitor array LDAC, as well as the capacitances of the capacitors in the MSB capacitor array MDAC, are weighted in powers of two. Due to factors including parasitic capacitance and a possible capacitance deviation of the bridge capacitor $C_b$ and capacitance mismatch of MDAC and LDAC, the weights of the capacitors may deviate from the ideal values. According to the present invention, the weights of the capacitors in the LSB capacitor array LDAC and the weights of the capacitors in the MSB capacitor array MDAC are calibrated, and the calibrated weights are stored as a matrix in an associated register and then used by the SAR logic and digital calibration module 20 in normal operation of the SAR ADC.

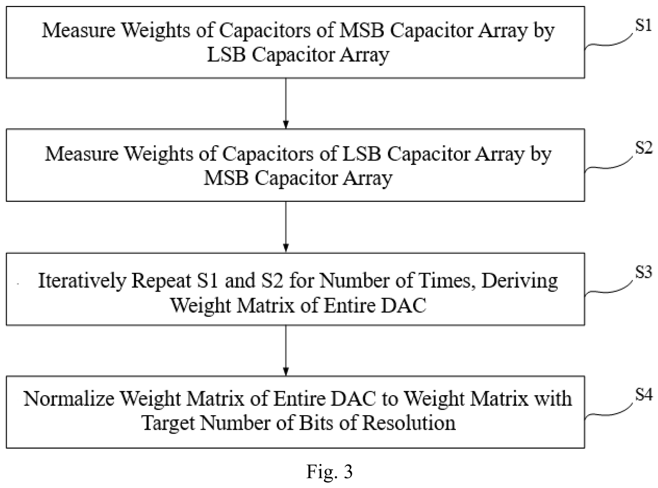

On this basis, with combined reference to Figs. 2 and 3, in an embodiment of the present invention, there is also provided a method of calibrating the weights of the capacitors in the SAR ADC prior to normal operation thereof. This method includes the steps of:

S1) measuring the weights of the capacitors in the MSB capacitor array MDAC by the LSB capacitor array LDAC;
S2) measuring the weights of the capacitors in the LSB capacitor array LDAC by the MSB capacitor array MDAC;
S3) iteratively repeating S1 and S2 for a number of times, deriving a weight matrix of the entire DAC; and
S4) normalizing the weight matrix of the entire DAC to a weight matrix with a target number of bits of resolution.

In this embodiment, initial values of the LDAC weights Weight_L=[Weight_L(m-1),..., Weight_L(0)] (i.e., ideal values of the LDAC weights initially during design) are $[2^{m-1}, 2^{m-2},...,2,1]$. In the SAR ADC calibration method of the present embodiment, when step S1 is carried out for the first time (i.e., during the first calibration), LDAC uses those initial values to measure (or calibrate) the weights of the MDAC capacitors. When step S1 is carried out for the second time, weight values obtained by performing calibration according to step S4 for the first time are used as Weight_L. Such iterations are repeated, in which Weight_L used in step S1 in each iteration is weight values obtained from calibration performed in step S4 in the previous iteration. The MSB capacitor array MDAC measures the weights of the capacitors in the LSB capacitor array LDAC by undergoing similar iterations, in which the weights Weight_M of the MSB capacitor array MDAC used in step S2 in each iteration is weight values obtained from calibration performed in step S4 in the previous iteration.

In the present embodiment, in step S1, the first ("1") input terminal of the multiplexer MUX is active for signal reception, and the LSB capacitor array LDAC, first comparator COMP1 and the SAR logic and digital calibration module 20 constitute an ADC loop ADC1.

For example, in step S1, the LSB capacitor array LDAC may first measure the weights of the terminal capacitor $CM_T$ and the least significant capacitor $CM_0$ in the MSB capacitor array MDAC and then successively the weights of the other capacitors $CM_1$-$CM_{k-1}$ of the MSB capacitor array MDAC.

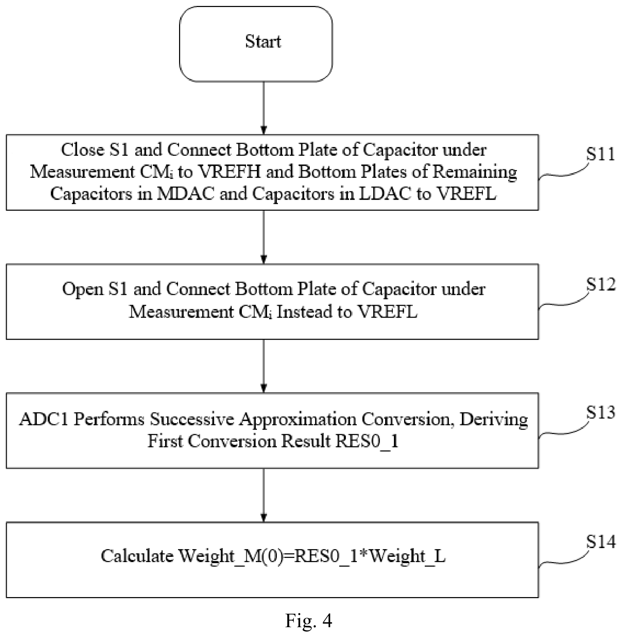

Referring to Fig. 4, in step S1, measuring the weights of the terminal capacitor $CM_T$ and the least significant capacitor $CM_0$ in the MSB capacitor array MDAC by the LSB capacitor array LDAC may include the sub-steps as detailed below.

In S11, the first switch S1 is closed, connecting the output terminal of the MSB capacitor array MDAC and the first ("+") input terminal of the first comparator COMP1 to the common-mode level VCM. Additionally, the bottom plate of the least significant capacitor $CM_0$ in the MSB capacitor array MDAC is connected to the first reference voltage VREFH, and the bottom plates of the terminal capacitor $CM_T$, the remaining capacitors $CM_1$-$CM_{k-1}$ of the MSB capacitor array MDAC and the capacitors $CL_0$-$CL_{m-1}$ in the LSB capacitor array LDAC are all connected to the second reference voltage VREFL.

In S12, the first switch S1 is opened, disconnecting the common-mode level VCM from the output terminal of the MSB capacitor array MDAC and from the first ("+") input terminal of the first comparator COMP1. Additionally, the bottom plate of the least significant capacitor $CM_0$ in the MSB capacitor array MDAC is instead connected to the second reference voltage VREFL.

In S13, the ADC loop ADC1 carries out successive approximation conversion, deriving a first conversion result RES0_1.

In S14, from the weights Weight_L=[Weight_L(m-1),..., Weight_L(0)] of the capacitors $CL_0$-$CL_{m-1}$ in the LSB capacitor array LDAC and the first conversion result RES0_1 , a digital circuit in the SAR logic and digital calibration module 20 derives the weight of the least significant capacitor $CM_0$ in MDAC as Weight_M(0)= RES0_1*Weight_L, where RES0_1*Weight_L is a matrix product, which determines, for each bit of RES0_1, the weight of the bit is to be added or not, depending on whether the bit is 1 or 0.

Optionally, in step S1, before step S14 is carried out, steps S11 to S13 may be repeated for a number of times, and the first conversion result RES0_1 may be obtained as an average of the repetitions. This allows for more accurate measurement of the weight of $CM_0$.

In this example, in step S1, the LSB capacitor array LDAC may measure the weight of the terminal capacitor $CM_T$ using the same process as is used to measure the weight of $CM_0$ (i.e., consisting of steps S11 to S14 as described above). That is, the first switch S1 is closed, and the bottom plate of the terminal capacitor $CM_T$ is connected to the first reference voltage VREFH and the bottom plate of each of the capacitors $CM_0$-$CM_{k-1}$ in the MSB capacitor array MDAC and the capacitors $CL_0$-$CL_{m-1}$ in the LSB capacitor array LDAC to the second reference voltage VREFL (corresponding to step S11). Subsequently, the first switch S1 is opened, and the bottom plate of the terminal capacitor $CM_T$ is instead connected to the second reference voltage VREFL (corresponding to step S12). The ADC loop ADC1 carries out successive approximation conversion, deriving a first conversion result RES0_1' (corresponding to step S13). The digital circuit in the SAR logic and digital calibration module 20 then derives, from the weights Weight_L=[Weight_L(m-1),..., Weight_L(0)] of the capacitors $CL_0$-$CL_{m-1}$ in LDAC and the conversion result RES0_1', the weight of the terminal capacitor $CM_T$ as Weight_M(T)=RES0_1'*Weight_L, where RES0_1'*Weight_L is a matrix product, which determines, for each bit of RES0_1', the weight of the bit is to be added or not, depending on whether the bit is 1 or 0.

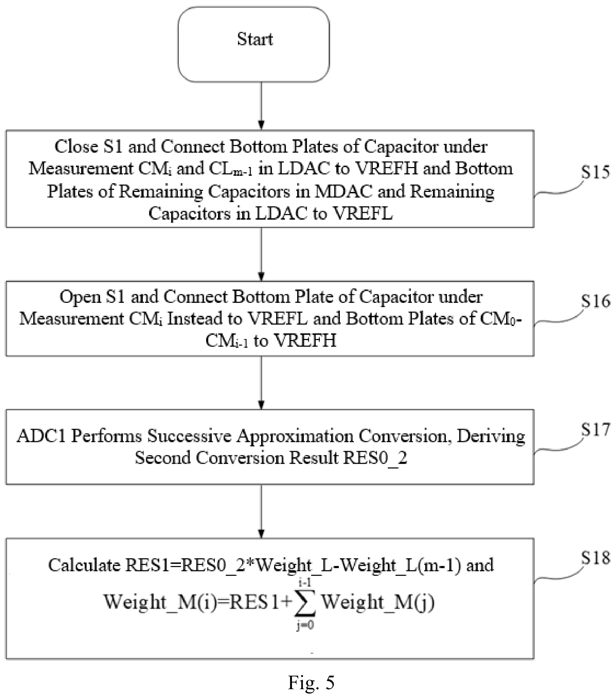

Referring to Fig. 5, in step S1, for each of the remaining capacitors $CM_1$-$CM_{k-1}$ whose weight is to be measured (referred to hereinafter as the "first capacitor under measurement $CM_i$", where $1 \leq i \leq k-1$), measuring the weight of the first capacitor under measurement $CM_i$ by the LSB capacitor array LDAC may include the sub-steps as detailed below.

In S15, the first switch S1 is closed, connecting both the output terminal of the MSB capacitor array MDAC and the first ("+") input terminal of the first comparator COMP1 to the common-mode level VCM. Additionally, the bottom plates of the first capacitor under measurement $CM_i$ and the most significant capacitor $CL_{m-1}$ in the LSB capacitor array LDAC are both connected to the first reference voltage VREFH, and the bottom plates of the terminal capacitor $CM_T$, the remaining capacitors $CM_0$-$CM_{i-1}$ and $CM_{i+1}$-$CM_{k-1}$ in the MSB capacitor array and the remaining capacitors $CL_0$-$CL_{m-2}$ in the LSB capacitor array are all connected to the second reference voltage VREFL.

In S16, the first switch S1 is opened, disconnecting the common-mode level VCM from the output terminal of the MSB capacitor array MDAC and the first ("+") input terminal of the first comparator COMP1. Moreover, the bottom plate of the first capacitor under measurement $CM_i$ is instead connected to the second reference voltage VREFL, and the bottom plates of capacitors in the MSB capacitor array MDAC of less significance than the first capacitor under measurement $CM_i$, i.e., the capacitors $CM_0$-$CM_{i-1}$, are all instead connected to the first reference voltage VREFH.

In S17, the ADC loop ADC1 carries out successive approximation conversion, deriving a second conversion result RES0_2.

In S18, from the weights Weight_L=[Weight_L(m-1),..., Weight_L(0)] of the capacitors $CL_0$-$CL_{m-1}$ in the LSB capacitor array LDAC and the second conversion result RES0_2, the digital circuit in the SAR logic and digital calibration module 20 determines the weight of the first capacitor under measurement $CM_i$ as:

$$\text{Weight\_M(i)} = \text{RES1} + \sum_{j=0}^{i-1} \text{Weight\_M(j)} \quad ,$$

$$\text{RES1} = \text{RES0\_2} * \text{Weight\_L} - \text{Weight\_L(m-1)},$$

and where i and j are both integers and satisfy $0 < i \leq k-1$ and $0 \leq j \leq i-1$.

Optionally, during the measurement of the weight of the first capacitor under measurement $CM_i$, before step S18 is carried out, steps S15 to S17 may be repeated for a number of times, and the second conversion result RES0_2 may be obtained as an average of the repetitions. This allows for more accurate measurement of the weights of the capacitors $CM_1$-$CM_{k-1}$.

In this way, through performing sub-steps S11 to S18 in step S1, the weight of the terminal capacitor $CM_T$ can be measured, and the weights of the capacitors $CM_0$-$CM_{k-1}$ in the MSB capacitor array MDAC can be obtained as MDAC_Weight =Weight_M=[Weight_M(k-1),..., Weight_M(0)].

In this embodiment, in step S2, the second ("0") input terminal of the multiplexer MUX is active for signal reception, and the MSB capacitor array MDAC, the second comparator COMP2 and the SAR logic and digital calibration module 20 constitute an ADC loop ADC2.

For example, in step S2, the MSB capacitor array MDAC may first measure the weight of the least significant capacitor $CL_0$ in the LSB capacitor array LDAC then successively the weights of the other capacitors $CL_1$-$CL_{m-1}$ of the LSB capacitor array LDAC.

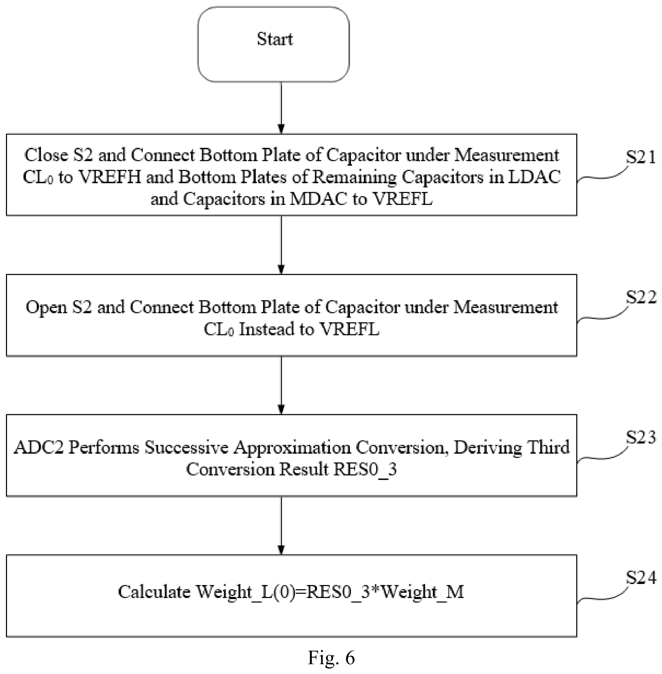

Referring to Fig. 6, in step S2, measuring the weight of the least significant capacitor $CL_0$ in the LSB capacitor array LDAC by the MSB capacitor array MDAC may include the sub-steps as detailed below.

In S21, the second switch S2 is closed, connecting the output terminal of the LSB capacitor array LDAC to the common-mode level VCM. Additionally, the bottom plate of the least significant capacitor $CL_0$ in the LSB capacitor array LDAC is connected to the first reference voltage VREFH, and the bottom plates of the terminal capacitor $CM_T$, the capacitors $CM_0$-$CM_{k-1}$ in the MSB capacitor array MDAC and the remaining capacitors $CL_1$-$CL_{m-1}$ of the LSB capacitor array LDAC are all connected to the second reference voltage VREFL.

In S22, the second switch S2 is opened, disconnecting the common-mode level VCM from the output terminal of the LSB capacitor array LDAC. Additionally, the bottom plate of the least significant capacitor $CL_0$ in the LSB capacitor array LDAC is instead connected to the second reference voltage VREFL.

In S23, the ADC loop ADC2 carries out successive approximation conversion, deriving a third conversion result RES0_3.

In S24, from the weights Weight_M=[Weight_M (k-1),..., Weight_M(0)] of the capacitors $CM_0$-$CM_{k-1}$ in the MSB capacitor array MDAC (i.e., the calibrated weights from step S1) and the third conversion result RES0_3, the weight of the least significant capacitor $CL_0$ in the LSB capacitor array LDAC is derived as Weight_L(0)=RES0_3*Weight_M, where RES0_3*Weight_M is a matrix product, which determines, for each bit of RES0_3, the weight of the bit is to be added or not, depending on whether the bit is 1 or 0.

Optionally, in step S2, before step S24 is carried out, steps S21 to S23 may be repeated for a number of times, and the third conversion result RES0_3 may be obtained as an average of the repetitions. This allows for more accurate measurement of the weight of $CL_0$.

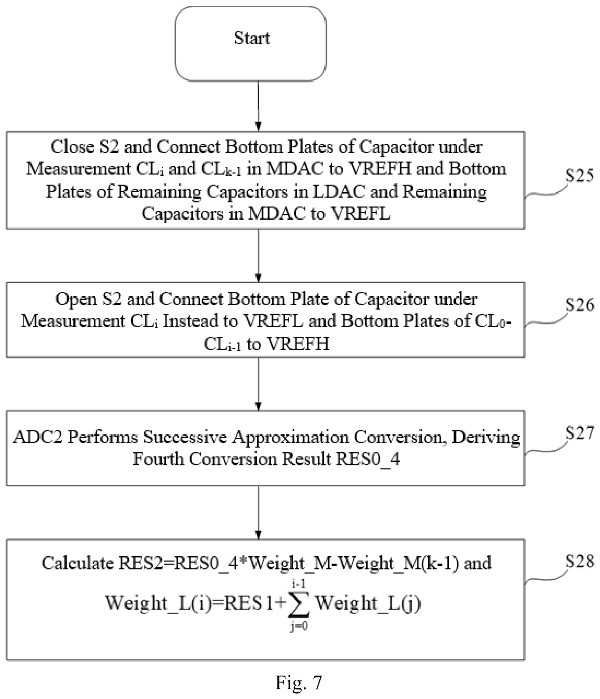

Referring to Fig. 7, in step S2, for each of the remaining capacitors $CL_1$-$CL_{m-1}$ whose weight is to be measured (referred to hereinafter as the "second capacitor under measurement $CL_i$", where $1 \leq i \leq m-1$), measuring the weight of the second capacitor under measurement $CL_i$ by the MSB capacitor array MDAC may include the sub-steps as detailed below.

In S25, the second switch S2 is closed, connecting both the output terminal of the LSB capacitor array LDAC and the first ("+") input terminal of the second comparator COMP2 to the common-mode level VCM. Additionally, the bottom plates of the second capacitor under measurement $CL_i$ and the most significant capacitor $CM_{k-1}$ in the MSB capacitor array MDAC are both connected to the first reference voltage VREFH , and the bottom plates of the terminal capacitor $CM_T$, the remaining capacitors $CM_0$-$CM_{k-2}$ in the MSB capacitor array MDAC and the remaining capacitors $CL_0$-$CL_{i-1}$ and $CL_{i+1}$-$CL_{m-1}$ in the LSB capacitor array LDAC are all connected to the second reference voltage VREFL.

In S26, the second switch S2 is opened, disconnecting the common-mode level VCM from the output terminal of the LSB capacitor array LDAC and the first ("+") input terminal of the second comparator COMP2. Moreover, the bottom plate of the second capacitor under measurement $CL_i$ is instead connected to the second reference voltage VREFL, and the bottom plates of capacitors in the LSB capacitor array LDAC of less significance than the second capacitor under measurement $CL_i$, i.e., the capacitors $CL_0$-$CL_{i-1}$, are all instead connected to the first reference voltage VREFH.

In S27, the ADC loop ADC2 carries out successive approximation conversion, deriving a fourth conversion result RES0_4.

In S28, from the weights of the capacitors in the MSB capacitor array MDAC and the fourth conversion result RES0_4, the digital circuit in the SAR logic and digital calibration module 20 derives the weight of the second capacitor under measurement $CL_i$ as:

$$\text{Weight\_L(i)=RES2+}\sum_{j=0}^{i-1}\text{Weight\_L(j)} \quad ,$$

$$\text{RES2=RES0\_4*Weight\_M-Weight\_M(k-1)},$$

and where i and j are both integers and satisfy 0<i≤k-1 and 0≤j≤i-1.

Optionally, in step S2, before step S28 is carried out, steps S25 to S27 may be repeated for a number of times, and the fourth conversion result may be obtained as an average of the repetitions. This allows for more accurate measurement of the weights of $CL_1$-$CL_{m-1}$.

In this way, through performing sub-steps S21 to S28 in step S2, the weights of the capacitors $CL_0$-$CL_{m-1}$ in the

LSB capacitor array LDAC can be obtained as Weight_L=[Weight_L(m-1),..., Weight_L(0)]. After that, the weights of the LDAC capacitors may be normalized by being divided by the weight Weight_L(0) of $CL_0$, i.e., LDAC_ Weight =Weight_L./ Weight_L (0)= [Weight_L (m-1),..., Weight_L (0)]./ Weight_L (0), wherein "./" represents a dot division operator.

In step S3, steps S1 and S2 are repeated for a number of times to increase the accuracy of MDAC_Weight and LDAC_Weight and derive a weight matrix DAC_Weight_raw=[MDAC_Weight, LDAC_Weight] of the entire DAC, wherein MDAC_Weight represents the weight matrix of the MSB capacitor array MDAC, and LDAC_Weight represents the weight matrix of the LSB capacitor array LDAC.

In step S4, the weight matrix DAC_Weight_raw of the entire DAC is normalized to a weight matrix with a target number of bits of resolution N, given as:

$$\mathrm{DAC\_Weight\_normal=DAC\_Weight\_raw.*} \left[ 2^N \Big/ \left( \sum \mathrm{MDAC\_Weight + Weight\_M\_(T)} \right) \right],$$

where N is at most m+k, $\sum$MDAC_Weight is the sum of the weights of the capacitors in the MSB capacitor array, ".*" represents a dot multiplication operator, Weight_M_(T) is the weight of the terminal capacitor $CM_T$ determined by the LSB capacitor array in steps S11 to S14 as described above.

Optionally, the weight matrix DAC_Weight_normal with the target number of bits of resolution N obtained in step S4 may be stored as digital values CAL DAC in an associated register of the SAR logic and digital calibration module 20. In normal operation of the SAR ADC, weight conversions can be performed on the DAC using the digital values CAL DAC stored in the register. Specifically, for each capacitor (or bit), its weight may be determined according to a corresponding comparator output, and may be added if it is determined to be 1. In this way, the SAR ADC can produce correct digital values.

Notably, in normal operation of the SAR ADC, some capacitors in the MSB capacitor array MDAC and some capacitors in the LSB capacitor array LDAC may be selected and used for sampling and conversion, as long as the sum of the weights of the selected capacitors in the LSB capacitor array LDAC is not smaller than the weight of the selected lowest bit of the MDAC and as long as the entire SAR ADC provides a target or design resolution. Furthermore, the SAR ADC may use more capacitors (bits) during calibration than in normal operation.

It will also be understood that, in the embodiment of Fig. 2, as only the first comparator COMP1 is used in normal operation of the SAR ADC, the second comparator COMP2 may be designed to have any suitable degree of accuracy as long as the calibration requirements are met.

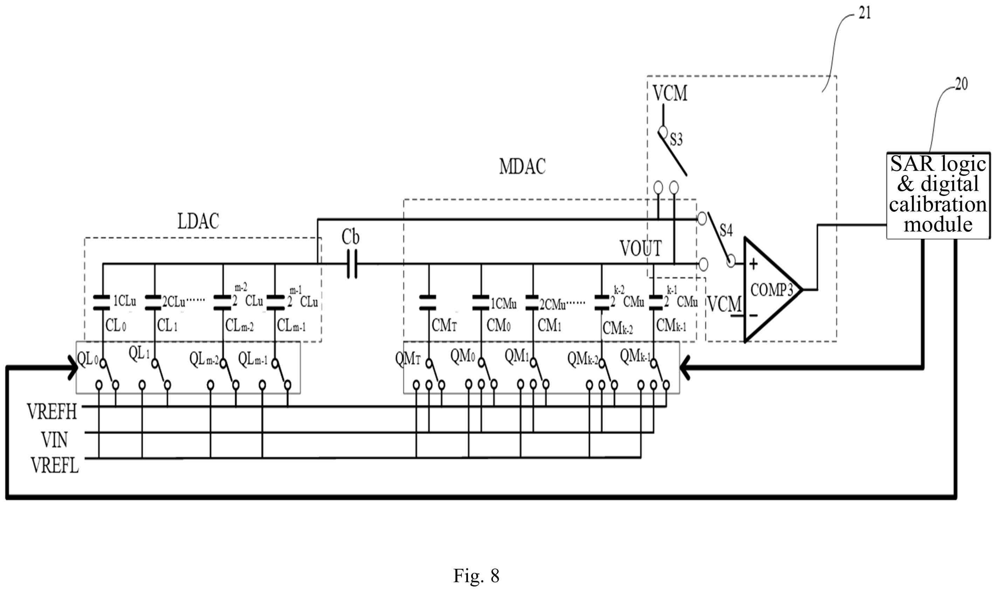

Further, as noted above, the comparison module 21 may be of any other suitable circuit design. For example, referring to Fig. 8, in an alternative implementation of the embodiment, the comparison module 21 may further include a third switch S3, a fourth switch S4 and a third comparator COMP3. A second ("-") input terminal of the third comparator COMP3 is coupled to the common-mode level VCM, and an output terminal of the third comparator COMP3 is coupled to the input terminal of the SAR logic and digital calibration module 20. One terminal of the third switch S3 is coupled to the common-mode level VCM, and another terminal thereof is selectively connected to the output terminal of the MSB capacitor array MDAC, or to the output terminal of the LSB capacitor array LDAC, as required by an intended calibration operation, or another terminal is connected to a first ("+") input terminal of the third comparator COMP3. One terminal of the fourth switch S4 is coupled to a first ("+") input terminal of the third comparator COMP3, and another terminal thereof is selectively connected to the output terminal of the LSB capacitor array LDAC, or to the output terminal of the MSB capacitor array MDAC, depending on whether calibration is to be carried out, or normal operation is to be initiated.

In this implementation, the third switch S3 and the fourth switch S4 can cooperate with each other to accomplish the connections and mutual weight calibrations in steps S1 and S2 as described above. Thus, the third comparator COMP3 can be reused in steps S1 and S2, and the multiplexer MUX may be omitted, resulting in a simpler circuit. For example, in step S1, the other terminal of the fourth switch S4 may be connected to the output terminal of the MSB capacitor array MDAC, and the third switch S3 may function equivalently to, and in place of, the first switch S1 to accomplish the operations in steps S11 to S18 as described above. In step S2, the other terminal of the fourth switch S4 may be connected to the output terminal of the LSB capacitor array LDAC, and the third switch S3 may function equivalently to, and in place of, the second switch S2 to accomplish the operations in steps S11 to S28 as described above. Further detailed description in this regard is omitted herein.

Therefore, in the SAR ADC and method of the present invention, each of the LSB and MSB capacitor arrays LDAC and MDAC in the DAC can be used to calibrate the weights of the capacitors in the other capacitor array. This dispenses with the use of a separate calibration DAC, resulting in a simpler circuit. In addition, the method can be carried out prior to normal operation of the SAR ADC, adding flexibility to initial design of the SAR ADC, in particular to capacitance design of the bridge capacitor $C_b$ and the segmented capacitor array design of the DAC.

Described above are merely a few preferred embodiments of the present invention, which are not intended to limit the scope of the present invention in any way. Any and all changes and modifications made by those of ordinary skill in the art in light of the above teachings are intended to fall within the scope of the invention.

**Claims**

1. A method of calibrating a successive approximation register (SAR) analog-to-digital converter (ADC), the SAR ADC comprising a digital-to-analog converter (DAC), the DAC comprising a bridge capacitor, a least significant bit (LSB) capacitor array and a most significant bit (MSB) capacitor array, the MSB capacitor array comprising capacitors each comprising a first electrode plate coupled to an electrode plate of the bridge capacitor, which provides an output terminal of the MSB capacitor array, the LSB capacitor array comprising capacitors each comprising a first electrode plate coupled to another electrode plate of the bridge capacitor, which provides an output terminal of the LSB capacitor array, the method comprising the steps of:

   S1) measuring weights of the capacitors of the MSB capacitor array by the LSB capacitor array;
   S2) measuring weights of the capacitors of the LSB capacitor array by the MSB capacitor array;
   S3) iteratively repeating steps S1 and S2 for a plurality of times, deriving a weight matrix of the entire DAC; and
   S4) normalizing the weight matrix of the entire DAC to a weight matrix with a target number of bits of resolution.

2. The method of claim 1, wherein in step S1, the weight of the least significant one of the capacitors in the MSB capacitor array is measured by the LSB capacitor array using a process comprising:

   S11) connecting the output terminal of the MSB capacitor array to a common-mode level, a second electrode plate of the least significant capacitor in the MSB capacitor array to a first reference voltage, and second electrode plates of the remaining capacitors in the MSB capacitor array and of the capacitors in the LSB capacitor array to a second reference voltage;
   S12) disconnecting the common-mode level from the output terminal of the MSB capacitor array and connecting the second electrode plate of the least significant capacitor in the MSB capacitor array instead to the second reference voltage;
   S13) performing successive approximation conversion by the SAR ADC, deriving a first conversion result; and
   S14) deriving the weight of the least significant capacitor in the MSB capacitor array from the weights of the capacitors in the LSB capacitor array and the first conversion result.

3. The method of claim 2, wherein in step S1, steps S11 to S13 are performed for a plurality of times prior to step S14, and the first conversion result is obtained as an average of the repetitions.

4. The method of claim 2, wherein in step S1, with each of the remaining capacitors in the MSB capacitor array to be measured being taken as a first capacitor under measurement, the weight of the first capacitor under measurement is measured by the LSB capacitor array using a process comprising:

   S15) connecting the output terminal of the MSB capacitor array to the common-mode level, the second electrode plates of the first capacitor under measurement and of the most significant one of the capacitors in the LSB capacitor array both to the first reference voltage, and the second electrode plates of the remaining capacitors in the MSB capacitor array and of the remaining capacitors in LSB capacitor array all to the second reference voltage;
   S16) disconnecting the common-mode level from the output terminal of the MSB capacitor array and connecting the second electrode plate of the first capacitor under measurement instead to the second reference voltage and the second electrode plates of capacitors in the MSB capacitor array of less significance than the first capacitor under measurement all instead to the first reference voltage;
   S17) performing successive approximation conversion by the SAR ADC, deriving a second conversion result; and
   S18) deriving the weight of the first capacitor under measurement from the weights of the capacitors in the LSB capacitor array and from the second conversion result.

5. The method of claim 4, wherein in step S1, steps S15 to S17 are performed for a plurality of times prior to step S18, and the second conversion result is obtained as an average of the repetitions.

6. The method of claim 4, wherein there are m capacitors $CL_0$-$CL_{m-1}$ in the LSB capacitor array, and weights of the m capacitors in the LSB capacitor array are expressed as Weight_L=[Weight_L(m-1),..., Weight_L(0)]; there are k

capacitors $CM_0$-$CM_{k-1}$ in the MSB capacitor array;

the weight of the least significant capacitor $CM_0$ in the MSB capacitor array is expressed as:

$$Weight\_M(0)=RES0\_1*Weight\_L;$$

the weight of the first capacitor under measurement $CM_i$ is expressed as:

$$Weight\_M(i)=RES1+\sum_{j=0}^{i-1} Weight\_M(j) \quad ,$$

where RES1=RES0_2*Weight_L-Weight_L(m-1); and
the weights of the capacitors in the MSB capacitor array are expressed as:

$$Weight\_M=[Weight\_M(k-1),..., Weight\_M(0)],$$

wherein RES0_1 represents the first conversion result, RES0_2 represents the second conversion result, and i and j are both integers and satisfy $0<i\leq k-1$ and $0\leq j\leq i-1$, and/or
the weights Weight_L of the capacitors in the LSB capacitor array are initially $[2^{m-1}, 2^{m-2},...,2,1]$.

7. The method of claim 1, wherein in step S2, the weight of the least significant one of the capacitors in the LSB capacitor array is measured by the MSB capacitor array using a process comprising:

   S21) connecting the output terminal of the LSB capacitor array to a common-mode level, a second electrode plate of the least significant capacitor in the LSB capacitor array to a first reference voltage, and second electrode plates of the remaining capacitors in the LSB capacitor array and of the capacitors in the MSB capacitor array to a second reference voltage;
   S22) disconnecting the common-mode level from the output terminal of the LSB capacitor array and connecting the second electrode plate of the least significant capacitor in the LSB capacitor array instead to the second reference voltage;
   S23) performing successive approximation conversion by the SAR ADC, deriving a third conversion result; and
   S24) deriving the weight of the least significant capacitor in the LSB capacitor array from the weights of the capacitors in the MSB capacitor array and from the third conversion result.

8. The method of claim 7, wherein in step S2, steps S21 to S23 are performed for a plurality of times prior to step S24, and the third conversion result is obtained as an average of the repetitions.

9. The method of claim 7, wherein in step S2, with each of the remaining capacitors in the LSB capacitor array to be measured being taken as a second capacitor under measurement, the weight of the second capacitor under measurement is measured by the MSB capacitor array using a process comprising:

   S25) connecting the output terminal of the LSB capacitor array to the common-mode level, the second electrode plates of the second capacitor under measurement and of the most significant one of the capacitors in the MSB capacitor array both to the first reference voltage, and the second electrode plates of the remaining capacitors in the MSB capacitor array and of the remaining capacitors in LSB capacitor array all to the second reference voltage;
   S26) disconnecting the common-mode level from the output terminal of the LSB capacitor array and connecting the second electrode plate of the second capacitor under measurement instead to the second reference voltage and the second electrode plates of capacitors in the LSB capacitor array of less significance than the second capacitor under measurement all instead to the first reference voltage;
   S27) performing successive approximation conversion by the SAR ADC, deriving a fourth conversion result; and
   S28) deriving the weight of the second capacitor under measurement from the weights of the capacitors in the MSB capacitor array and from the fourth conversion result,
   optionally, in step S2, steps S25 to S27 are performed for a plurality of times prior to step S28, and the fourth conversion result is obtained as an average of the repetitions.

**10.** The method of claim 9, wherein there are m capacitors $CL_0$-$CL_{m-1}$ in the LSB capacitor array and k capacitors $CM_0$-$CM_{k-1}$ in the MSB capacitor array, and the weights of the capacitors in the MSB capacitor array are expressed as weight

$$\text{Weight\_M}=[\text{Weight\_M(k-1)},\ldots, \text{Weight\_M(0)}];$$

the weight of the least significant capacitor $CL_0$ in the LSB capacitor array is expressed as:

$$\text{Weight\_L(0)}=\text{RES0\_3}*\text{Weight\_M};$$

the weight of the second capacitor under measurement $CL_i$ is expressed as:

$$\text{Weight\_L(i)}=\text{RES2}+\sum_{j=0}^{i-1} \text{Weight\_L(j)} \quad,$$

where RES2=RES0_4*Weight_M-Weight_M(k-1); and
the weights of the capacitors in the LSB capacitor array are expressed as:

$$\text{Weight\_L}=[\text{Weight\_L(m-1)},\ldots, \text{Weight\_L(0)}]./\ \text{Weight\_L(0)},$$

wherein RES0_3 represents the third conversion result, RES0_4 represents the fourth conversion result, and i and j are both integers and satisfy $0<i\leq m-1$ and $0\leq j\leq i-1$.

**11.** The method of claim 6 or 10, wherein the m capacitors $CL_0$-$CL_{m-1}$ and the k capacitors $CM_0$-$CM_{k-1}$ are both weighted in powers of two; the segmented capacitor array further comprises a terminal capacitor; the weight matrix of the entire DAC in step S3 is obtained as DAC_Weight_raw= [MDAC_Weight, LDAC _Weight]; and the weight matrix with the target number of bits of resolution N in step S4 is obtained as

$$\text{DAC\_Weight\_normal}=\text{DAC\_Weight\_raw}.*\left[2^N\middle/\left(\sum \text{MDAC\_Weight} + \text{Weight\_M\_(T)}\right)\right] \quad,$$

where $\sum$MDAC_Weight is the sum of the weights of the capacitors in the MSB capacitor array, and/or Weight_M_(T) is a weight of the terminal capacitor measured by the LSB capacitor array.

**12.** A successive approximation register (SAR) analog-to-digital converter (ADC), comprising:

a digital-to-analog converter (DAC) comprising a bridge capacitor, a least significant bit (LSB) capacitor array and a most significant bit (MSB) capacitor array, the MSB capacitor array comprising capacitors each comprising a first electrode plate coupled to an electrode plate of the bridge capacitor, which provides an output terminal of the MSB capacitor array, the LSB capacitor array comprising capacitors each comprising a first electrode plate coupled to another electrode plate of the bridge capacitor, which provides an output terminal of the LSB capacitor array,
a comparison module (21), comprising: a first input terminal coupled to both the output terminal of the LSB capacitor array and the output terminal of the MSB capacitor array; and a second input terminal coupled to a common-mode level, the comparison module (21) configured to compare an output of the MSB capacitor array or of the LSB capacitor array with the common-mode level; and
a SAR logic and digital calibration module (20) comprising an input terminal coupled to an output terminal of the comparison module (21), the SAR logic and digital calibration module (20) configured to perform successive approximation conversion based on an output of the comparison module (21) and thereby implement the method of any one of claims 1 to 11.

**13.** The SAR ADC of claim 12, wherein each of the capacitors in the DAC comprises a second electrode plate coupled to a corresponding switch, and the SAR logic and digital calibration module (20) is also configured to control each of the capacitors in the DAC so that the second electrode plate of the corresponding capacitor is switched to be connected to at least one of a first reference voltage, a second reference voltage and an input voltage.

14. The SAR ADC of claim 12, wherein the comparison module (21) comprises:

a first switch and a first comparator, the first switch comprising a terminal coupled to the common-mode level and another terminal coupled to both a first input terminal of the first comparator and the output terminal of the MSB capacitor array, the first comparator comprising a second input terminal coupled to the common-mode level; a second switch and a second comparator, the second switch comprising a terminal coupled to the common-mode level and another terminal coupled to both a first input terminal of the second comparator and the output terminal of the LSB capacitor array, the second comparator comprising a second input terminal coupled to the common-mode level; and a multiplexer comprising a first input terminal coupled to an output terminal of the first comparator, a second input terminal coupled to an output terminal of the second comparator and an output terminal coupled to an input terminal of the SAR logic and digital calibration module (20), wherein the multiplexer routes a result of comparison from the first comparator to the SAR logic and digital calibration module (20) to allow the LSB capacitor array to measure weights of the capacitors in the MSB capacitor array, and routes a result of comparison from the second comparator to the SAR logic and digital calibration module (20) to allow the MSB capacitor array to measure weights of the capacitors in the LSB capacitor array.

15. The SAR ADC of claim 12, wherein the comparison module (21) comprises:

a third comparator comprising a second input terminal coupled to the common-mode level and an output terminal coupled to an input terminal of the SAR logic and digital calibration module (20); a third switch comprising a terminal coupled to the common-mode level and another terminal selectively coupled to the output terminal of the MSB capacitor array or to the output terminal of the LSB capacitor array or to a first input terminal of the third comparator; and a fourth switch comprising a terminal coupled to the first input terminal of the third comparator and another terminal selectively coupled to the output terminal of the LSB capacitor array or to the output terminal of the MSB capacitor array.

Fig. 1

EP 4 776 515 A1

Fig. 2

Measure Weights of Capacitors of MSB Capacitor Array by LSB Capacitor Array — S1

Measure Weights of Capacitors of LSB Capacitor Array by MSB Capacitor Array — S2

Iteratively Repeat S1 and S2 for Number of Times, Deriving Weight Matrix of Entire DAC — S3

Normalize Weight Matrix of Entire DAC to Weight Matrix with Target Number of Bits of Resolution — S4

Fig. 3

Start

Close S1 and Connect Bottom Plate of Capacitor under Measurement $CM_i$ to VREFH and Bottom Plates of Remaining Capacitors in MDAC and Capacitors in LDAC to VREFL — S11

Open S1 and Connect Bottom Plate of Capacitor under Measurement $CM_i$ Instead to VREFL — S12

ADC1 Performs Successive Approximation Conversion, Deriving First Conversion Result RES0_1 — S13

Calculate Weight_M(0)=RES0_1*Weight_L — S14

Fig. 4

Start

Close S1 and Connect Bottom Plates of Capacitor under Measurement CM$_i$ and CL$_{m-1}$ in LDAC to VREFH and Bottom Plates of Remaining Capacitors in MDAC and Remaining Capacitors in LDAC to VREFL — S15

Open S1 and Connect Bottom Plate of Capacitor under Measurement CM$_i$ Instead to VREFL and Bottom Plates of CM$_0$-CM$_{i-1}$ to VREFH — S16

ADC1 Performs Successive Approximation Conversion, Deriving Second Conversion Result RES0_2 — S17

Calculate RES1=RES0_2*Weight_L-Weight_L(m-1) and
$$\text{Weight\_M}(i)=\text{RES1}+\sum_{j=0}^{i-1}\text{Weight\_M}(j)$$ — S18

Fig. 5

Start

Close S2 and Connect Bottom Plate of Capacitor under Measurement $CL_0$ to VREFH and Bottom Plates of Remaining Capacitors in LDAC and Capacitors in MDAC to VREFL — S21

Open S2 and Connect Bottom Plate of Capacitor under Measurement $CL_0$ Instead to VREFL — S22

ADC2 Performs Successive Approximation Conversion, Deriving Third Conversion Result RES0_3 — S23

Calculate Weight_L(0)=RES0_3*Weight_M — S24

Fig. 6

```
                    ┌─────────────────┐
                    │      Start      │
                    └────────┬────────┘
                             │
                             ▼
┌──────────────────────────────────────────────────────────┐
│  Close S2 and Connect Bottom Plates of Capacitor under     │  S25
│  Measurement CLi and CLk-1 in MDAC to VREFH and Bottom     │
│  Plates of Remaining Capacitors in LDAC and Remaining      │
│           Capacitors in MDAC to VREFL                       │
└──────────────────────────┬─────────────────────────────────┘
                             │
                             ▼
┌──────────────────────────────────────────────────────────┐
│  Open S2 and Connect Bottom Plate of Capacitor under       │  S26
│  Measurement CLi Instead to VREFL and Bottom Plates of CL0-│
│             CLi-1 to VREFH                                   │
└──────────────────────────┬─────────────────────────────────┘
                             │
                             ▼
┌──────────────────────────────────────────────────────────┐
│  ADC2 Performs Successive Approximation Conversion, Deriving│  S27
│         Fourth Conversion Result RES0_4                     │
└──────────────────────────┬─────────────────────────────────┘
                             │
                             ▼
┌──────────────────────────────────────────────────────────┐
│  Calculate RES2=RES0_4*Weight_M-Weight_M(k-1) and          │  S28
│                                                            │
│  Weight_L(i)=RES1+∑Weight_L(j)                             │
└──────────────────────────────────────────────────────────┘
```

Close S2 and Connect Bottom Plates of Capacitor under Measurement $CL_i$ and $CL_{k-1}$ in MDAC to VREFH and Bottom Plates of Remaining Capacitors in LDAC and Remaining Capacitors in MDAC to VREFL — S25

Open S2 and Connect Bottom Plate of Capacitor under Measurement $CL_i$ Instead to VREFL and Bottom Plates of $CL_0$-$CL_{i-1}$ to VREFH — S26

ADC2 Performs Successive Approximation Conversion, Deriving Fourth Conversion Result RES0_4 — S27

Calculate RES2=RES0_4*Weight_M-Weight_M(k-1) and

$$\text{Weight\_L}(i) = \text{RES}1 + \sum_{j=0}^{i-1} \text{Weight\_L}(j)$$

— S28

Fig. 7

Fig. 8

## EUROPEAN SEARCH REPORT

**Application Number**

EP 26 15 0969

### DOCUMENTS CONSIDERED TO BE RELEVANT

| Category | Citation of document with indication, where appropriate, of relevant passages | Relevant to claim |
|---|---|---|
| A | CN 111 431 529 B (CHENGDU MECS MICROELECTRONICS TECH CO LTD) 6 June 2023 (2023-06-06) * paragraph [0117]; figures 1,3,7-9 * ----- | 1-15 |

**CLASSIFICATION OF THE APPLICATION (IPC)**

INV.
H03M1/10
H03M1/46

**TECHNICAL FIELDS SEARCHED (IPC)**

H03M

The present search report has been drawn up for all claims

| Place of search | Date of completion of the search | Examiner |
|---|---|---|
| The Hague | 31 May 2026 | Jesus, Paulo |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
   ........................................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 26 15 0969

This annex lists the patent family members relating to the patent documents cited in  the above-mentioned European search report.
The members are as contained in the European Patent Office EDP file on
The European Patent Office is in no way liable for these particulars which are merely given for the purpose of information.

31-05-2026

| Patent document cited in search report | Publication date | Patent family member(s) | Publication date |
|---|---|---|---|
| CN 111431529 B | 06-06-2023 | NONE | |

EPO FORM P0459

For more details about this annex : see Official Journal of the European Patent Office, No. 12/82